# EUROPEAN PATENT APPLICATION

(11) **EP 4 848 502 A2**
(43) Date of publication of application: **02.12.2026**
(21) Application number: 26182159.9
(22) Date of filing: 30.05.2026
(51) Int. Cl.: H01S 5/062, H01S 5/10, H01S 5/042

(54) **LASER TRANSISTOR DEVICE**

(30) Priority: 30.05.2025 PL 45221625; 29.05.2026 PL 45591226
(71) Applicant: Ensemble3 spolka z ograniczona odpowiedzialnoscia, 01-919 Warszawa (PL)
(72) Inventor: Otsuji, Taiichi, 01-909 Warszawa (PL); Bandopadhyay, Kingshuk, 01-840 Warszawa (PL); Materna, Andrzej, 03-455 Warszawa (PL); Markus, Krzysztof, 01-355 Warszawa (PL); Pawlak, Dorota Anna, 01-885 Warszawa (PL)
(74) Representative: JD&P Patent Attorneys Joanna Dargiewicz & Partners

(57) **Abstract**

The invention relates to a laser transistor device consisting of:
(a) a layered back-gate element (1) consisting of a substrate layer (1A), a metal electrode layer (1B), and a gate insulating layer (1C),
(b) a thin-channel element (2) consisting of vertically stacked thin semi-metallic layers (2A) and vertically stacked thin semiconductor or insulating layers (2B), which are arranged layer by layer in an alternating lamellar manner and placed on top of the stacked back-gate element,
(c) an upper gate element (3) consisting of an insulating layer (3A) and a metal electrode layer (3B), arranged on top of the insulating layer (3A),
(d) a first lateral contact layer of a metal electrode, referred to as a "source," which is embedded in order to make electrical contact with one side wall perpendicular to the direction of the layer of a pillar gate element later, and
(e) a second lateral metal electrode layer, referred to as a "drain," which is embedded in order to make electrical contact with a second side wall perpendicular to the direction of the pillar gate element layer.

## Description

The object of the invention is a Laser transistor device.

The following is a comprehensive overview of trends in the scaling of silicon CMOS circuits, More-than-Moore and Beyond-CMOS technologies, bottlenecks in achieving cutoff frequencies >1-THz cut-off frequencies in transistors, and recent advances in the field of THz plasmonic laser transistors.

### 1.1. Trends and Limitations in the Scaling of Silicon CMOS Circuits

Scaling Trends (Moore's Law) [1]
- Dennard scaling (up to 90 nm): Transistor dimensions, voltage, and power scaled together → higher performance and density at a constant power density.
- Post-Dennard era (≤65 nm): Voltage scaling has slowed due to leakage and reliability; dynamic power and heat have become critical limitations.
- FinFET and GAA (Gate-All-Around):
   ∘ FinFET (22 nm and below): Improved electrostatic properties and short-channel control.
   ∘ Nanosheet/GAA FET (3 nm and above): Further improvements in gate control and scalability.
- 3D Integration: Through-Silicon Vias (TSV), 3D NAND, and logic/memory chips to overcome area constraints. III-V GAA (Gate-All-Around) core-shell nanowire FETs are emerging, but mass production is a major challenge.

Physical and practical limitations [2], [3]
- Gate length below ~5 nm:
   ∘ Short-channel effects
   ∘ Quantum tunneling degrading on/off efficiency
   ∘ Variability
- Contact resistance and parasitic capacitance increase as dimensions shrink, degrading speed and operating frequency.
- Heat dissipation and interconnect delays have a dominant impact on system performance.
- Mass performance of 3D integrated devices [4],[5]

### 1.2. More-than-Moore and Beyond-CMOS Technologies

1) More-than-Moore: Extends the capabilities of CMOS through heterogeneous integration
   - RF and analog integration: Combines RF, analog, digital, and MEMS on the same array. [6]
   - 2.5D/3D heterogeneous packaging: Integration of photonics, power, MEMS, and sensors. [7]
   - System-on-Chip (SoC) and System-in-Package (SiP) solutions. [8]
   - Transistors operating in the THz frequency range using plasmonic waves: Transition from conventional electronic THz oscillators to unconventional electronic, plasmonic THz laser transistors [9].
2) Beyond-CMOS devices: Research into new materials and principles [10]
3) New transistor technologies encompassing both More-than-Moore and Beyond-CMOS devices:
   - III-V and 2D materials (e.g., InGaAs, graphene, MoS₂, WS₂): [11]
      ∘ Higher mobility than Si → faster switching.
      ∘ Potential for ballistic transport.
   - Carbon nanotube field-effect transistors (CNT-FETs): [12]
      ∘ Extremely high mobility and transport close to ballistic.
      ∘ Good electrostatic properties due to the 1D structure.
   - Spintronic and ferroelectric FETs: [12]
      ∘ No drift and alternative switching mechanisms.
   - Tunneling FETs (TFETs): [13]
      ∘ SS below 60 mV/decade for low-power operation.
      ∘ Currently limited by the control current.
   - Integration of optoelectronics and photonics: [14]
      ∘ Enables the creation of high-bandwidth, low-latency connections.

### 1.3. Barriers (limitations) for cutoff frequencies >1 THz (fT) in transistors and laser transistors

### Internal device limitations: [15-17]

- Carrier Transit Time: Requires very short channels with high-mobility materials.
- Gate capacitance and parasitic resistance: Must be minimized for high fT (current gain cutoff frequency defined as the point where current gain becomes 0 dB (output equals input).
- Speed saturation: Even for high-mobility materials, speed saturation limits the speed under high-electric-field conditions routinely observed in a nanometer-scale transistor channel with a specific charge density at specific drain-source and gate-source voltage applications.

### Material challenges: [15-17]

- Contact resistance in 2D/CNT/III-V materials: Remains a key bottleneck.
- Material quality and homogeneity: Defects and variability reduce performance.
- Heterogeneous integration of high-mobility materials with CMOS is challenging, but there are no practical implementations yet.

### Thermal management: [15-17]

- High-frequency devices generate significant amounts of heat.
- The thermal conductivity of 2D and III-V materials is often lower than that of silicon.

### Manufacturing and scalability: [15-17]

- Alignment/sorting of CNTs and synthesis of 2D materials are not yet ready for industrial application.
- Process variability in nodes below 5 nm significantly affects repeatability.

### Packaging and interconnects: [15-17]

- Interconnect delay and signal integrity become more dominant at >1 THz.
- Parasitic effects associated with the packaging of structures can overshadow the transistor's operating speed.

Limitations of existing coherent THz light sources in integrated device structures:
- RTD (Resonant Tunneling Diode) oscillators: were subject to scaling laws and severely attenuated radiation output with increasing frequency, ceasing operation beyond the record-high frequency of 1.98 THz. [18]
- QCLs (Quantum Cascade Lasers): 1-3 THz lasing at room temperature has been achieved in a self-mixing mode using dual-oscillating mid-infrared laser lights; however, these are only partial solutions and suffer from poor optical quality and stability of the emitted light due to phonon decoherence effects. [19]

### 1.4. Recent Advances in the Application of 2D Plasmon Instability for Continuous THz Generation

Current-driven 2D plasmon instability in a transistor structure:
- **Nonlinear dynamics of 2D plasmons and instability:** Hydrodynamic nonlinearity of 2D plasmons in semiconductor quantum wells or a transistor channel layer can promote an unstable self-oscillating displacement current flow when a specifically confined region acting as a plasmonic cavity is defined by boundaries with a high charge density fraction. As the cavity size decreases to the micrometer scale with a charge density of 10¹² cm⁻², the resonant plasmon oscillation shifts into the THz range. If the plasmons are well damped, the oscillation becomes a continuous emission of coherent THz radiation [20].
- **Plasmon Q-factor:** The Q-factor is simply modeled as the product of the angular frequency under consideration and the carrier lifetime (momentum relaxation time). Thus, the carrier transport property (how long carriers can survive without scattering) directly limits the plasmon Q-factor. Even when applied to graphene, which offers the highest mobility and longest carrier lifetime, the Q-factor of THz plasmon oscillations remains below 10 at room temperature [21].
- **Plasmon suppression:** Plasmon suppression can occur due to perturbations caused by the excitation of unwanted auxiliary plasmon modes, such as substrate plasmons [22], as well as oblique plasmons, which can quench the primary plasmon resonances [23].
- **Experimental confirmations:** THz emission has been experimentally demonstrated using III-V compound semiconductor heterostructure quantum wells in HEMT (high-electron-mobility transistor) structures, the inversion layer in the Si MOSFET (metal-oxide semiconductor field-effect transistor), as well as graphene FET channels [9, 24]. However, even in the case of graphene FETs with the highest carrier transport properties, the unstable THz light amplification remains at 9% (less than 10%) [25]. An innovative structure of a flat channel etched into multi-channel strips works well for suppressing transverse plasmons, but suffers from process complexity and poor reproducibility [26].

Toward plasmonic THz laser transistors:
- **Current-injected THz laser transistor:** Optically or electrically pumped graphene generates negative dynamic conductivity and net gain in the THz range. This phenomenon was first discovered theoretically [27, 28] and demonstrated experimentally [29], but its quantum efficiency is significantly limited to below 2.3% [27]. This suggests that current pumping serves only to generate the THz lasing seed, and an amplifier is necessary to produce practically acceptable intense radiation emission [29].
- **Concept for a plasmonic THz laser transistor:** Integrating a current-pumped laser seed generation block and a coherent THz light amplifier block driven by plasmonic instability into a single-laser transistor matrix will overcome many limiting factors and bring us closer to the successful operation of a THz laser transistor at room temperature [9]. However, the quantum efficiency barrier remains.

In summary, following key barriers in current technology have been identified:
1) Flat channel structures are approaching the scaling limit of Si-CMOS technology;
2) Gate-All-Around (GAAR) 3D channel structures, as well as nanowires, are candidates for mitigating short-channel effects, which is an advantage for 1 THz operation, but they suffer from poor current efficiency and mass production challenges, which is a disadvantage for 1 THz operation. To address this significant issue, a new concept and structure must be introduced;
3) A multi-channel planar strip structure is a promising solution for suppressing plasmon suppression and increasing the Q-factors of plasmonic cavities in the channel and the resulting increase in coherent THz emission power, as demonstrated experimentally, but it suffers from costly process complexity and poor process repeatability;
4) When considering coherent THz light sources operating at room temperature within an integrated device structure, currently available RTD (resonant tunnel diodes) are a rare solution, but they are subject to scaling laws and severely attenuate their radiative output power as frequency increases, and have ceased operation beyond the record-high frequency of 1.98 THz [19]. Another rare solution is QCLs (quantum cascade lasers) in self-mixing mode with double-beat laser lights in the mid-infrared, but they suffer from poor optical quality and stability of the emitted light due to phonon decoherence effects [20];
5) To date, neither ideas nor proposals for the introduction of eutectic heterostructures have been put forward as a method to overcome technological limitations regarding the high-speed and high-frequency performance of transistor devices.

### Problem-Solving Methods

The present invention aims to solve the aforementioned problems in existing technology and enable a high-frequency, high-speed transistor operating above 1 THz, as well as enable coherent THz radiation emission with high output power intensity and high quantum efficiency at energy consumption orders of magnitude than in existing technology for room-temperature integrated coherent THz light source devices.

To achieve this: the invented "laser transistor device" essentially consists of:
a) a layered back-gate element 1 consisting of a substrate layer 1A, a metal electrode layer 1B, and a gate insulating layer 1C,
b) a thin-channel element 2 consisting of vertically stacked thin semi-metallic layers 2A and vertically stacked thin semiconductor or insulating layers 2B, which are arranged layer by layer in an alternating lamellar manner and placed on top of the stacked back-gate element,
c) an upper gate element 3 consisting of an insulating layer 3A and a metal electrode layer 3B, arranged on top of the insulating layer 3A,
d) a first lateral contact layer of a metal electrode, referred to as a "source," which is embedded in order to make electrical contact with one side wall perpendicular to the direction of the layer of a pillar gate element later, and
e) a second lateral metal electrode layer, referred to as a "drain," which is embedded in order to make electrical contact with a second side wall perpendicular to the direction of the pillar gate element layer.

In one embodiment, the layered back-gate element 1 comprises a substrate layer 1A, a metal electrode layer 1B, and a gate insulating layer 1C, in that order from bottom to top.

In another embodiment, the layered back-gate element 1 is formed of a metal electrode layer 1B, a substrate layer 1A, and a gate insulating layer 1C in that order from bottom to top, wherein a low-resistance substrate layer 1A is used, acting as an extension of the metal electrode layer 1B.

In another embodiment, a) the metal electrode layer 1B in the back gate element 1 is completely covered by the area of the thin-channel element 2 and b) the metal electrode layer 1B in the upper gate element 3 is formed in the shape of a single narrow finger running perpendicular to the source-drain direction.

In another embodiment, the metal electrode layer 1B in the element stacked with the back gate 1 and in the element stacked with the upper gate 3 is formed in the shape of a single narrow finger running perpendicular to the source-drain direction and are arranged so that they overlap.

In another embodiment, the metal electrode layer 1B in the element stacked with the back gate 1 and in the element stacked with the upper gate 3 is formed in the shape of a double grating gate, in which one grating gate electrode is nested with the other grating gate electrode, and the double grating gate electrode in the element stacked with the back gate 1 and in the element stacked with the upper gate 3 are arranged so that they overlap.

In another embodiment, the distance from one gate finger to the gate finger adjacent on the left and to the gate finger adjacent on the right is different from each other.

In another embodiment, the thin-channel element 2 consists of vertically arranged thin semi-metallic layers 2A and vertically arranged thin semiconductor or insulating layers (2B), which are arranged layer by layer in an alternating, plate-like manner, wherein the thickness of each individual layer ranges from 10 nanometers to 10 micrometers, such that conduction electrons or valence holes in the vertically arranged thin semi-metallic layers (2A) can be quantum mechanically constrained.

In another embodiment, the thin-channel element 2 consists of vertically stacked thin semi-metallic layers 2A and vertically stacked thin semiconducting or insulating layers 2B, which are arranged layer by layer in an alternating, tile-like manner, the height of the vertically stacked channel is between 10 nanometers and 10 micrometers, so that the induced charge densities within the vertically stacked thin semi-metallic layers 2A can be well controlled electrostatically by applying a voltage to the element with a back gate 1 and the element with a upper gate 3.

In another embodiment, the thin-channel element 2 consists of vertically stacked thin semi-metallic layers 2A and vertically stacked thin semiconducting or insulating layers 2B, which are arranged layer by layer in an alternating lamellar manner, is made of two different two-dimensional [2D] topological Dirac semimetals and/or transition metal chalcogenides and/or thin van der Waals insulating layers, which are arranged via van der Waals forces without chemical bonds through exfoliation and dry transfer treatment.

In another embodiment, the thin-channel element 2 consists of vertically arranged thin semi-metallic layers 2A and vertically arranged thin semiconductor or insulating layers 2B, which are arranged layer by layer in an alternating lamellar manner, is made of two different topological insulating materials in a eutectic alloyed lamellar heterostructure.

In another embodiment, the thin-channel element 2, consisting of vertically arranged thin semi-metallic layers 2A and vertically arranged thin semiconductor or insulating layers 2B, which are arranged layer by layer in an alternating lamellar fashion, is made of a semimetal and a semiconductor or insulating material.

In another embodiment, the metal electrode layer 3B in c) the upper gate element is formed in a double-grating-gate structure, in which two independent grating-finger-shaped electrodes are laid out in an interdigitated fashion and are electrically connected to independent top gate terminals (named Gate1 and Gate 2, respectively). Wherein, said double-grating-gate structure itself is well-known existing technology as is seen in Wilkinson RJ et al., J. Appl. Phys. 71 (12), 6049-6061 (1992). https://doi.org/10.1063/1.350462. Unexpectedly, the current invention introduces this element as a part of the embodiment to create a new function to promote the Coulomb drag instability which is never realized by the double-grating-gate structure itself.

In another embodiment, the grating-gate electrode in the double-grating-type metal electrode layer 3B is asymmetrically laid out with respect to the other grating-gate electrode so as to inequal the distances between adjacent left-side grating-gate finger and adjacent right-side grating finger. Wherein, the asymmetric positioned grating-gate electrode in the double-grating-type metal electrode layer with respect to the other grating-gate electrode as a structure itself is known from US9018683 B2. Unexpectedly, the current invention introduces this element as a part of the embodiment to create to create a new function to promote the Coulomb drag instability which is never realized by the double-grating-gate structure itself.

With regard to the stacked back gate element 1, consisting of a substrate layer 1A, a metal electrode layer 1B, and a gate insulating layer 1C arranged in a layered configuration, a different layer order may be used;
Option 1: substrate layer 1A, metal electrode layer 1B, and gate insulation layer 1C in the order from bottom to top, and
Option 2: metal electrode layer 1B, substrate layer 1A, and gate insulation layer 1C in the order from bottom to top. In the latter case, the substrate must be low-resistance, functioning as part of the conductive metal electrode layer.

As for the back gate element 1 and the upper gate element 3, the metal electrode layer 1B may have different shapes.
First option: the metal electrode layer 1B in the back gate element 1 is completely covered by the area of the thin-channel element 2, and the metal electrode layer 1B in the upper gate element 3 is shaped like a single narrow finger running perpendicular to the source-drain direction;
Second option: the metal electrode layer 1B in the element stacked with the back gate 1 and in the element stacked with the upper gate 3 are formed in the shape of a single narrow finger running perpendicular to the source-drain direction and are arranged so that they overlap;
Third option: the metal electrode layer 1B in the element stacked with the back gate 1 and in the element stacked with the upper gate 3 are formed in the shape of a double grating gate, in which one grating gate electrode is nested with the other grating gate electrode, and the double grating gate electrode in the element stacked with the back gate 1 and in the element stacked with the upper gate 3 are arranged so that they overlap.
Fourth option: in the case of the aforementioned double-grated gate structure, the distance from one grated gate finger to the adjacent grated gate finger on the left and to the adjacent finger on the right is arranged differently.

With regard to the thin-channel element 2, consisting of vertically stacked thin semi-metallic layers 2A and vertically stacked thin semiconducting or insulating layers 2B, which are arranged layer by layer in an alternating lamellar manner, the thickness of each individual layer should be between 10 nanometers and 10 micrometers, so that the conduction electrons or valence holes in the vertically stacked thin semi-metallic layers 2A can be quantum mechanically confined.

With respect to the thin channel element 2, consisting of vertically stacked thin semi-metallic layers 2A and vertically stacked thin semiconducting or insulating layers 2B, which are arranged layer by layer in an alternating lamellar manner, the height of the vertically arranged channel should be between 10 nanometers and 10 micrometers, so that the induced charge densities within the vertically arranged thin semi-metallic layers 2A can be well controlled electrostatically by applying a voltage to the element arranged on the rear gate 1 and the element arranged on the upper gate 3.

With regard to thin-channel element 2, consisting of vertically stacked thin semi-metallic layers 2A and vertically stacked thin semiconducting or insulating layers 2B, which are arranged layer by layer in an alternating lamellar manner, it can be prepared using various materials and synthesis methods.
First option: consists of two different two-dimensional (2D) topological semimetals, Dirac semimetals, and/or transition metal chalcogenides, and/or layered thin van der Waals insulating layers, referred to as vdWHetero, which are stacked via van der Waals forces without chemical bonds through exfoliation and dry transfer processing;
Second option: consists of two different topological insulating materials in a eutectic alloyed heterostructure wafer, referred to as EuHetero;
Third option: consists of a semimetal and a semiconductor or insulating materials.

The invention is illustrated in the exemplary embodiments and in the figures, wherein
Fig. A1a shows a VP-TI-EuHetero FET: A typical case for implementing a device structure with a back gate and a top single-gate electrodes and the vertically pillared (VP) topological insulator (TI) and semiconductor eutectic lamellar heterostructure (EuHetero) as the channel material.
Fig. A1b shows a VP-TI-EuHetero FET: Another typical case for implementing a device structure with a back gate and a top ADGG: asymmetric dual-grating gate electrodes and the vertically pillared (VP) topological insulator (TI) and semiconductor eutectic lamellar heterostructure (EuHetero) as the channel material.
Fig. A2 shows examples of van der Waals (vdW) heterostructured gate stacking in a planar transistor structure.
Fig. A3a shows our ENSEMBLE3-original Bi2Te3/Te eutectic heterostructures. Growth apparatus of the BieTe3/Te eutectic lamellar heterostructure (left top), as grown ingot rod (left bottom), SEM image (left center bottom), and Raman 2D mapping (right top) and spectra for Bi₂Te₃ (green) and Te (red);
Fig. A3b introduces shows a Band Alignment for Bi2Te3/Te EuHetero Structures. Energy band diagram identified by the ARPES measurement (right center bottom), periodic unintentionally n-doped Bi2Te3 and unintentionally p-doped Te lamellar band diagram as grown (center top) (Bandopadhyay, M. Buza, C. Chen, A. Materna, K. Szlachetko, P. Piotrowski, H.B. Surma, J. Borysiuk, R. Diduszko, A. Barinov, Y.L. Chen, M. Kaminska, and D.A. Pawlak, Self-organized topological insulator heterostructures via eutectic solidification of Bi2Te3-Te. Next Materials 5, 100252 (2024). DOI: 10.1016/j.nxmate.2024.100252). Angle-Resolved Photo-Emission Spectroscopy (ARPES) measurements identified the energy band alignment as shown here. A rather thick Bi₂Te₃ (far more than 10 quintuple layers) have a bandgap energy ~170 meV (close to the 3D bulk) looks semimetallic, whereas Te has the bandgap of ~330 meV looks semiconducting. The unintentionally n-doped Bi₂Te₃ and unintentionally p-doped Te form a p-n junction. Thus, the Bi₂Te₃/Te eutectic lamellar heterostructure forms periodic p-n junctions.
Fig. A4 shows the implementation of the TI-EuHetero Lamellar striped channel into a planar transistor with PI's original asymmetric dual-grating-gate (ADGG) structure. The asymmetric dual-grating-gate (ADGG) structure used herein corresponds to the structure disclosed in EP2648290 A1, which attributes the effect of strong light-matter coupling and improved THz radiation detection responsivity to this structure. However, said prior art does not disclose or even suggest the merit for promoting the Coulomb-drag instability in the EuHetero lamellar channel structure disclosed herein.
Fig. A5 shows a key bottleneck in THz lasing is overdamping by oblique plasmon modes (Dyakonov M et al., Semiconductors 2008, 42, 984). In a standard planar 2D channel in a transistor, electro-statically confined electrons under the gate finger can excite the plasmons, which are the quanta of collective charged electron density waves, not only for resonant cavity modes (schematically shown with solid arrows) along with the drain-source channel directions but also, any oblique modes (schematically shown with dashed arrows). Dr. Dyakonov theoretically discovered that these oblique plasmons strongly damp the resonant cavity plasmon modes. To avoid such oblique plasmons scientists mechanically processed to etch the 2D planar channel into a 100-nm-down-scaled striped shape, succeeding in observation of the enhancement of plasmon resonance at cryogenic temperature. However, the sample under measurement was III-V semiconductor quantum wells so that the electron transport properties are insufficient to manifest clear improvement on the resonance at room temperature. Also, the poor reproducibility originated from the costly fine etching process suffers from industrialization.
   This is the fundamental bottleneck to realize room-temperature, intense THz lasing performances. And, we will break through this technological barrier by introducing our patent-pending TI-EuHetero lamellar-channel transistor structure. Its unique 2.5D lamellar architecture-periodic TI layers preserving 2D dispersion-enables gate-controlled channel striping and improved plasmon confinement, ensuring scalability and reproducibility, which will be introduced in the following figures.
Fig. A6a schematically shown the energy band diagrams under different Gate1/Gate2 bias conditions. Without Gate1/Gate2 biasing, initially unintentionally n-doped Bi₂Te₃ and unintentionally p-doped Te forms a rather balanced p-n junction;
Fig. A6b schematically shows how to promote the Coulomb-drag plasmon instability in the device structure claimed in No. 13 and No. 14. Gate1 and Gate2 are complimentary biased positively and negatively, respectively. Under the Bi₂Te₃ lamellar layered channel, heavily n-doped Bi₂Te₃ under Gate1 and lightly p-doped or intrinsic Bi₂Te₃ under Gate2.

### Practical examples of the invention

### Example 1

A typical implementation of the device structure is explained here, assuming the following options:
Regarding the layer sequence in the stacked element with back gate 1, the following is assumed:
   Option 1: substrate layer 1A, metal electrode layer 1B, and gate insulation layer 1C, in that order from bottom to top.
Regarding the shape of the metal electrode layer 1B in the back gate element 1 and the upper gate element 3, the following is assumed:
   Option 3: The metal electrode layer 1B in the back gate element 1 and in the upper gate element 3 are formed in the shape of a double grating gate as claimed in claim 13, in which one grating gate electrode is nested within the other grating gate electrode, and the double grating gate electrodes in the back gate element 1 and in the upper gate element 3 are arranged so that they overlap, and
   Fourth option: in the case of the aforementioned double grating gate configuration, the distance between one grating gate finger and the adjacent grating gate finger on the left side and the adjacent finger on the right side is arranged differently as claimed in claim 14.

### Example 2

With regard to the materials and synthesis of thin-channel element 2, the following is assumed:
Firstly, the first option: it consists of two different two-dimensional (2D) topological Dirac semimetals and/or transition metal chalcogenides and/or thin van der Waals insulating layers, which are stacked using van der Waals forces without chemical bonds via exfoliation and dry transfer; here we call this a 2D van der Waals heterostructure, abbreviated as vdWHetero;
Secondly, the second option: it consists of two different topological insulator materials in a eutectic alloy lamellar heterostructure, called EuHetero.

### A cross-section and bird's-eye view of its structure are shown in Fig. A1.

### Example 3

Thin-channel element 2 consists of two different topologically insulated materials in a eutectic alloy lamellar heterostructure, referred to as "EuHetero".

EuHetero is placed on a flat substrate with back gate 1 such that the plate is oriented vertically.

One side of the semi-metallic lamellar layers is separated by other semiconducting or insulating lamellar layers (whose bandgap is wider than that of the semi-metallic layer) due to the nature of EuHetero.

The EuHetero material is thinned to approximately micro- or submicrometers, and then an upper gate 3 element is formed.

Finally, the vertical sidewalls of the EuHetero lamellar structure are metallized to form the "source" electrode 4 and the "drain" electrode 5.

EuHetero can form multiple vertical semi-metallic channels in the FET structure.

It now functions as a top-and-bottom double-gated FET with multiple 2.5D channels.

Regarding the vdWHetero material for the thin-channel element 2, various options can be introduced, such as the heterostacking of graphene and hexagonal BN vdW shown in Fig. A2, the heterostacking of graphene and black phosphorus, Bi₂Se₃, the Dirac topological semimetal, and the heterostacking of h-BN, etc.

In one embodiment, the EuHetero material for the thin-channel element 2 shown in Fig. A2 is selected from: Bi₂Te₃, a Dirac topological semimetal, and Te semiconductor stacked in a lamellar structure.

The implementation method of the thin-channel element 2 using the VP-3D-EuHetero MC structure is shown schematically in Figs. A1 and A4. Fig. A4 illustrates a typical method and sequence for the entire manufacturing process, starting with a flat substrate stacked with a back gate 1, followed by the thin-channel element 2, an upper element stacked with upper gate 3, one side metal contact electrode layer called the "source" 4, and a second side metal contact electrode layer called the "drain" 5.

Regarding the metal electrode layer on one side, referred to as the "source" 4, and the metal electrode layer on the other side, referred to as the "drain" 5, several options can be introduced, such as the standard Ti/Pt/Au formulation using vapor deposition and thermal annealing, as well as another standard formulation of Au/Ge/Ni eutectic metal alloys similarly using vapor deposition and thermal annealing [R1, R2] and/or a recently developed composite material with a covalent organic framework (COF) structure, such as polyarylether (PAE) and/or a highly defective carbon-integrated polymer composite [R3-R5], as well as cross-linked microporous polymers [R6].

EuHetero is, by nature, a bulk, three-dimensional (3D) material. This makes it unsuitable as a conventional 2D channel material for planar transistor structures. To address this, PC came up with a new idea. It is called a vertically pillar-type multi-channel 3D-EuHetero structure (VP-3D-EuHetero MC).

Cross-sectional views of its structure are shown in Fig. A3a.

A lamellar-layered bulk crystal of EuHetero is placed on top of a flat substrate with a back gate, such that the lamellae are oriented in a vertical pillar-like manner.

One side of the semi-metallic lamellar layers is separated by other insulating lamellar layers due to the nature of EuHetero.

EuHetero can form multiple vertically pillar-like semi-metallic channels within the FET structure.

The EuHetero material is thinned to approximately micro- to submicrometer thicknesses, followed by the deposition of the top gate stack layers.

Finally, the sidewalls perpendicular to the lamellar direction of the EuHetero are metallized to form ohmic source and drain contacts.

It now functions as a top-bottom-side-gated, double-sided 2.5D-like field-effect transistor with multiple pillar channels.

Compared to a conventional planar field-effect transistor, its current controllability can be greatly increased.

While simultaneously suppressing the diagonal plasmon excitation of the main plasmon-suppression-promoting factor, the plasmon resonance killer.

Compared to conventional planar FETs, their current efficiency can be significantly increased while suppressing oblique plasmon excitation, which is the primary factor promoting plasmon damping-the "killer" of plasmon resonance-as shown in Fig. A5.

The proposed materials and device structure could implement all the required physics to break through the technological limitations towards room-temperature intense THz lasing and amplification!! Let us introduce plasmon instability physics behind the device structure claimed as No. 13 and No. 14 under specific drain-source and Gate1/Gate2 biases conditions.

Fig. A6a schematically shown the energy band diagrams under different Gate1/Gate2 bias conditions. Without Gate1/Gate2 biasing, initially unintentionally n-doped Bi₂Te₃ and unintentionally p-doped Te forms a rather balanced p-n junction. When a negative Gate bias is applied, holes are attracted in the EuHetero channel. Thus, p-doped Te is more deeply p-doped, whereas n-doped Bi₂Te₃ reduces the density of electrons of the majority carrier towards intrinsic and/or further inverted lightly p-doped. On the contrary, when a positive Gate bias is applied, electrons are attracted in the EuHetero channel. Thus, p-doped Te reduces holes of the majority carrier towards intrinsic and/or further inverted lightly n-doped, whereas n-doped Bi₂Te₃ is more deeply n-doped. In summary, the channel conductivity/resistivity can be modulated by application of the Gate1/Gate2 bias voltages and their polarities, giving rise to a cross-check spatial distribution of the conductivity profile as shown in the left panel schematic.

Figure A6b schematically shows how to promote the Coulomb-drag plasmon instability in the device structure claimed in No. 13 and No. 14. Gate1 and Gate2 are complimentary biased positively and negatively, respectively. Under the Bi₂Te₃ lamellar layered channel, heavily n-doped Bi₂Te₃ under Gate1 and lightly p-doped or intrinsic Bi₂Te₃ under Gate2. When a relevant dc Drain-Source bias voltage is applied, the potential will be sloped along the channel direction downward to the Drain electrode. As a result, periodic potential cliffs with an inverted potential slope near the Bi₂Te₃ region under Gate2 may mediate the dragged motion to the confined electrons when the thermally excited electrons are ballistically injected from the prior adjacent potential cliff, resulting in negative conductance. Due to the plasmon cavity defined by the ADGG-Gate1 gate finger width, the negative conductance will be resonantly enhanced at plasmon resonant mode frequencies. When the ADGG finger width is designed on the order of submicrometers and the gate-bias-forced confined electron density stays on the order of 10¹² cm⁻², the fundamental mode of resonant oscillation frequency will fall in the terahertz range. The ADGG structure can yield a cascading action of the Coulomb-drag instability. Thus, enormous enhancement of coherent self-oscillatory terahertz electromagnetic radiation will be realized by the Phase-3 TI-EuHetero striped channel ADGG FETs.

### Evaluation of the invention and its effectiveness compared to existing technology

To evaluate the performance improvement relative to state-of-the-art technology, we modeled the new laser transistor device and analyzed its performance for laser operation with output power and operating temperature at 1 THz as performance metrics.

We named this newly proposed device structure "VP-3D-EuHetero MC," which stands for "Vertically Pillared 3-Dimensional Eutectic Heterostructure-materials Multi-Channel."

**Table A1. Evaluation of the invention's effectiveness relative to a conventional Monolayer-GR-FET structure**

| Category | Description | Features | MLG* and DS* instability factor | Added value |
|---|---|---|---|---|
| Material | Low-dimensional topological insulators (Bi₂Se₃, Bi₂Te₃) with asymmetric Dirac cones | the electron mass of light | 0.5 | |
| | | Suppresses Auger scattering | 2.0 | |
| Physics | Coulomb resistance instability | higher NDC* | 2.0 | |
| | Active PT symmetry control | Higher amplitude gain | 2.0 | |
| | | Ultra-fast gain switch | - | > 100 Gb/s Direct coding |
| Device | VP-3D-EuHetero MC | Removal of oblique plasmons 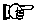 Reduces plasmon suppression 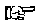 higher Q | 3.0 | |
| | | Improved performance Q | 10.0 | |
| Total improvement rate | | | 120.0 | |

| | | | | |
|---|---|---|---|---|
| MLG: single-layer graphene; DS: Dyakonov-Shur; NDC: negative differential conductance. | | | | |

### References

[1] "The International Technology Roadmap for Semiconductors (ITRS)"
   - Source: ITRS Reports (https://irds.ieee.org)
   - Covers historic and future CMOS scaling trends, including FinFET, GAA, and 3D integration.
[2] Bohr, M. T. & Young, I. A. (2017) "CMOS Scaling Trends and Beyond." IEEE Micro
   - DOI: 10.1109/MM.2017.4241347
   - Insightful overview of physical limits and technology evolution.
[3] Frank, D. J. et al. (2001) "The future of CMOS technology." IBM Journal of Research and Development
   - Classic reference on fundamental CMOS scaling issues.
[4] Gamo H. et al. (2023) "Selective-Area Growth of Vertical InGaAs/GaSb Core-Shell Nanowires on Silicon and Dual Switching Properties." 17, 18346-18351. ACS Nano
   - III-V GAA (Gate-All-Around) core-shell nanowire FET on Si.
[5] Katsumi Y. et al. (2024) "InP Crystal Phase Heterojunction Transistor with a Vertical Gate-All-Around Structure." 16, 30471-30477. ACS Appl. Mater. Interfaces.
   - InP crystal phase heterojunction GAA (Gate-All-Around) core-shell nanowire FET on InP.
[6] Rabaey, J. et al. (2020) "More-than-Moore: Expanding the Limits of Semiconductor Scaling." Proceedings of the IEEE
   - DOI: 10.1109/JPROC.2020.3005681
   - Excellent coverage of heterogeneous integration and system-level innovations.
[7] Jan C.-H. et al. (2015) "A 14nm SoC platform technology featuring 2nd generation Tri-Gate transistors, 70nm gate pitch, and 52nm metal pitch." Kyoto, Japan, 2015, pp. T12-T13, 2015 Symp. On VLSI Circuits
   - DOI: 10.1109/VLSIC.2015.7231380.
   - Real-world application of advanced More-than-Moore CMOS nodes.
[8] Isaac R.D. (2000) "The future of CMOS technology."44(3), 369-378 IBM Journal of Research and Development
   - DOI:10.1147/rd.443.0369
   - Classic reference on fundamental CMOS scaling issues.
[9] Otsuji T. et al. (2022) ""Graphene-based plasmonic metamaterial for terahertz laser transistors," 11(9), 1677-1696 Nanophotonics
   - DOI: 10.1515/nanoph-2021-0651
   - 2D Dirac plasmons in graphene and its instability enable coherent THz lasing and amplification in an FET structure even at room temperature. Remaining bottleneck is the plasmon damping and rather poor quantum efficiencies.
[10] ITRS Beyond-CMOS Working Group (2015) "Beyond CMOS: Benchmarking Emerging Technologies."
   - https://www.semiconductors.org/wp-content/uploads/2018/06/6_2015-ITRS-2.0-Beyond-CMOS.pdf
   - Extensive survey of alternative transistor paradigms.
[11] Schwierz, F. (2010) "Graphene transistors." Nature Nanotechnology
   - DOI: 10.1038/nnano.2010.89
   - Overview of graphene's potential and limitations.
[12] Franklin, A. D. (2015) "Nanomaterials in transistors: From high-performance to thin-film applications." Science
   - DOI: 10.1126/science.aab2750
   - Covers CNTs, 2D materials, and future nanoelectronic devices.
[13] Seabaugh, A. C. & Zhang, Q. (2010) "Low-Voltage Tunnel Transistors for Beyond CMOS Logic." Proceedings of the IEEE
   - DOI: 10.1109/JPROC.2010.2043031
   - Potentials and prospects and bottlenecks for tunnel FETs.
[14] Shi Z. et al. (2022) "Two-dimensional materials toward Terahertz optoelectronic device applications." J. Photochemistry and Photobiology C: Photochemistry Reviews
   - DOI: 10.1016/j.jphotochemrev.2021.100473
   - A comprehensive review of 2D materials and their applications in THz generation devices, modulator, THz shielding, and photodetectors.
[15] del Alamo, J. A. (2011) "Nanometre-scale electronics with III-V compound semiconductors." Nature
   - DOI: 10.1038/nature10677
   - One of the best overviews of high-speed III-V devices.
[16] Ajayan J. et al. (2018) " InP high electron mobility transistors for submillimetre wave and terahertz frequency applications: A review" AEU - Int. J. Electron. Comm.
   - DOI: 10.1016/j.aeue.2018.07.015
   - Explains fabrication, challenges, and performance limits of THz transistors.
[17] Wang, B., Wang, H., Bao, Y. et al. (2025) "Sustainable Materials Enabled Terahertz Functional Devices." 17, 212. Nano-Micro Lett.
   - DOI: 10.1007/s40820-025-01732-1
   - Explores the developmental prospects of integrating sustainable materials with THz functional devices, presenting their potential applications in the future.
[18] Suzuki S., Asada M. (2024) "Fundamentals and recent advances of terahertz resonant tunneling diodes." 17, 070101. Appl. Phys. Exp.
   - DOI: 10.35848/1882-0786/ad5c27
   - Review the historical development of RTD oscillators towards 2 THz at room temperature. Substantial physical limits make difficult to far exceeds the barrier of 2 THz emission.
[19] Fujita K. et al. (2018) "Recent progress in terahertz difference-frequency quantum cascade laser sources." 7(11) 1795-1817. Nanophotonics
   - DOI: 10.1515/nanoph-2018-0093
   - succeeded in 1-3 THz lasing at room temperature by self photomixing mode with dual-oscillating mid-infrared laser lights, but suffering from less quality, unstable oscillation.
[20] Dyakonov M., Shur M. (1996) ""Graphene based plasma-wave devices for terahertz applications," 116, 140501. (invited, perspective) Phys. Rev. Lett.
   - DOI: 10.1063/1.5140712
   - Graphene plasmonic device designs is promising for THz applications, but challenges still remaining in producing uniform, high-quality large graphene mono-, bi-, and hetero-layers with low resistance stable Ohmic contacts.
[21] Ryzhii V. et al. (2020) ""Graphene based plasma-wave devices for terahertz applications," 116, 140501. (invited, perspective) Appl. Phys. Lett.
   - DOI: 10.1063/1.5140712
   - Graphene plasmonic device designs is promising for THz applications, but challenges still remaining in producing uniform, high-quality large graphene mono-, bi-, and hetero-layers with low resistance stable Ohmic contacts.
[22] Satou A. et al. (2014) "Damping mechanism of terahertz plasmons in graphene on heavily doped substrate." 115, 104501. J. Appl. Phys.
   - DOI: 10.1063/1.4867971
   - Theoretical discovery for the strong damping effect by the electrostatic coupling with the heavily-doped substrate modes of perturbed plasmons.
[23] Dyakonov M. (2008) "Boundary Instability of a Two-Dimensional Electron Fluid." 42(8), 984-988. Semiconductors
   - DOI: 10.1134/S1063782608080186
   - Theoretical discovery for the strong damping effect for the excitation of oblique angled plasmons to the main plasmon modes.
[24] Otsuji T. et al. (2014) "Emission and detection of terahertz radiation using two-dimensional plasmons in semiconductor nanoheterostructures for nondestructive evaluations." 53(3), 031206. Opt. Eng.
   - DOI: 10.1117/1.OE.53.3.031206
   - Review plasmonic THz emission and detection using III-V semiconductor heterostructures.
[25] Boubanga-Tombet S. et al. (2020) "Room-Temperature Amplification of Terahertz Radiation by Grating-Gate Graphene Structures." 10, 031004. Phys. Rev. X
   - DOI: 10.1103/PhysRevX.10.031004
   - World-first room-temp. amplification of stimulated emission of THz radiation via plasmon instability in a graphene-channel FET structure featured by asymmetric dual-grating gates.
[26] Boubanga-Tombet S. et al. (2008) "Current driven resonant plasma wave detection of terahertz radiation: Toward the Dyakonov-Shur instability." 92, 212101. Appl. Phys. Lett.
   - DOI: 110.1063/1.2936077
   - Planar channel etched into a striped-multi-channel structure works well but suffering from the process complexity and poor reproducibility.
[27] Ryzhii V. et al. (2007) "Negative dynamic conductivity of graphene with optical pumping." 101, 0083114. J. Appl. Phys.
   - DOI: 10.1063/1.2717566
   - Theoretical discovery of producing a gain in the THz range in graphene by optical pumping.
[28] Otsuji T. et al. (2013) "Terahertz-Wave Generation Using Graphene: Toward New Types of Terahertz Lasers." 19, 8400209. IEEE J. Sel. Top. Quantum Electron.
   - DOI: 10.1109/JSTQE.2012.2208734
   - Theoretical approval for realization of current-injection THz lasing in graphene transistors.
[29] Yadav D. et al. (2018) "Terahertz light-emitting graphene-channel transistor toward single-mode lasing." 7(4), 741-752. Nanophotonics
   - DOI: 10.1515/nanoph-2017-0106
   - World-first experimental demonstration of THz lasing from current-injection graphene transistors. The operating temp. was limited <100K and the output power under 10 µW.

[R1] Binari, S. C., and Boos, J. B. (1989). AuGe/Au ohmic contacts to n-type InP by hot-plate alloying. Electron. Lett. 25(15), 1015-1016. Doi: 10.1049/el:19890810
[R2] Lin H.-C., Senanayake S., Cheng K.-Y., Hong M., Raynien Kwo J., Yang B., and Mannaertz J.P. (2003). Optimization of AuGe-Ni-Au ohmic contacts for GaAs MOSFETs. IEEE Trans. Electron Dev., 50(4), 880-885. Doi: 10.1109/TED.2003.812097
[R3] Nagai A. Covalent Organic Frameworks, Jenny Stanford Publishing, 226 pages, Feb. 2020. ISBN 9789814800877.
[R4] Li, N. et al. (2021). Polyarylether-Based 2D Covalent-Organic Frameworks with In-Plane D-A Structures and Tunable Energy Levels for Energy Storage. Advanced Science 9(6) 2104898. DOI: 10.1002/advs.202104898
[R5] Deverdran A., Nagai A. Covalent organic framework-derived highly defective carbon-integrated polymer composite electrode for supercapacitor applications. ACS Appl. Energy Mater. 8, 2597-2611. DOI: 10.1021/acsaem.4c03219
[R6] Veldhuizen H. et al. Cahrge-transfer-complexed conjugated microporous polymers (CT-CMPs). Micromol. Chem. Phys. 221, 1900415. DOI: 10.1002/macp.201900415

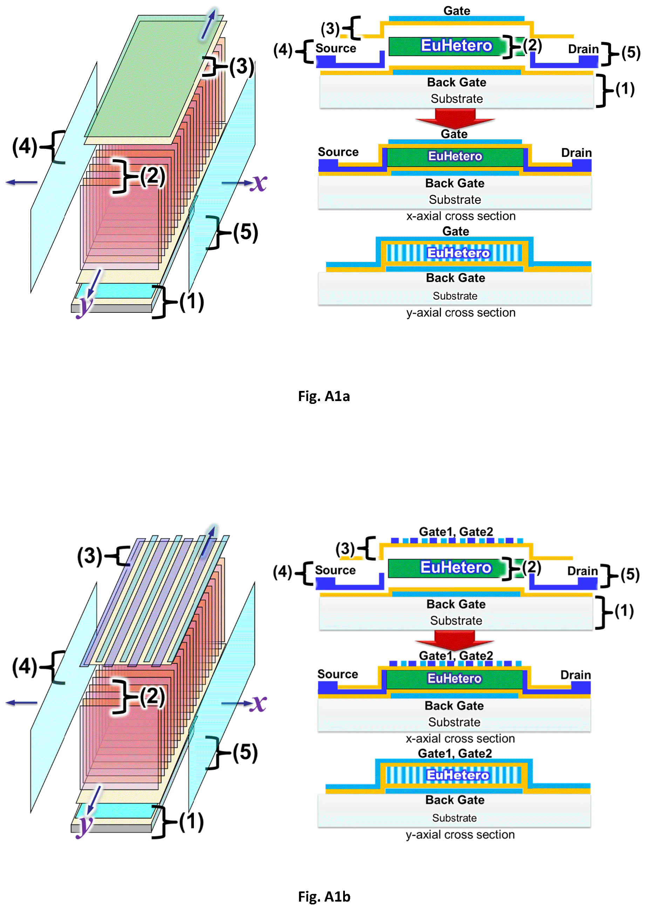

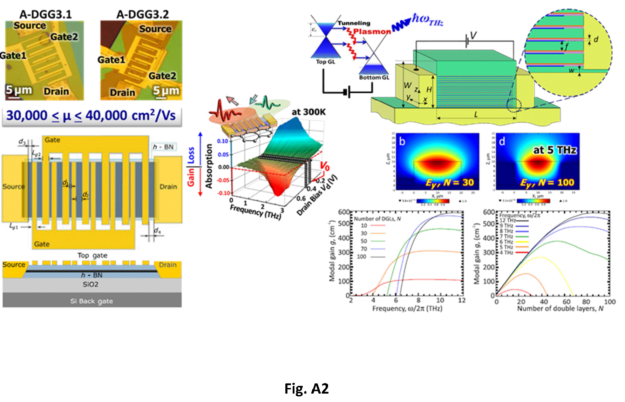

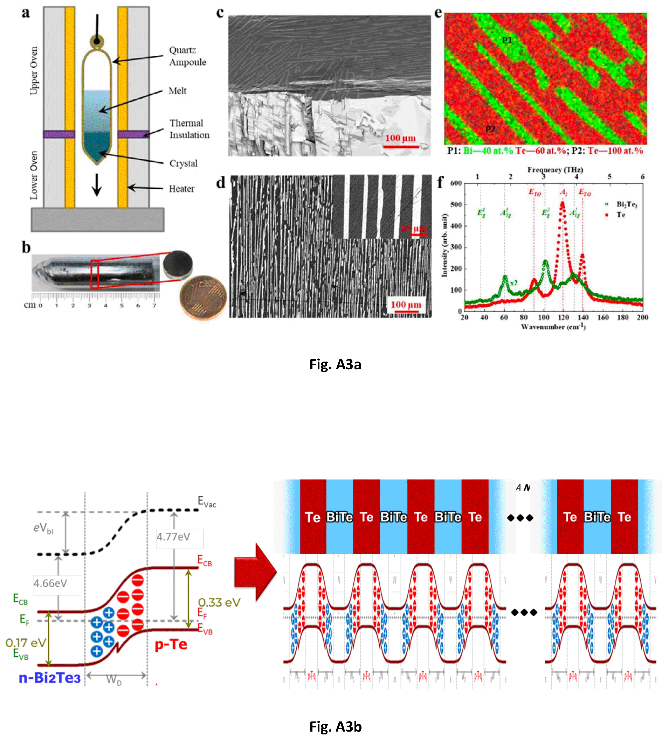

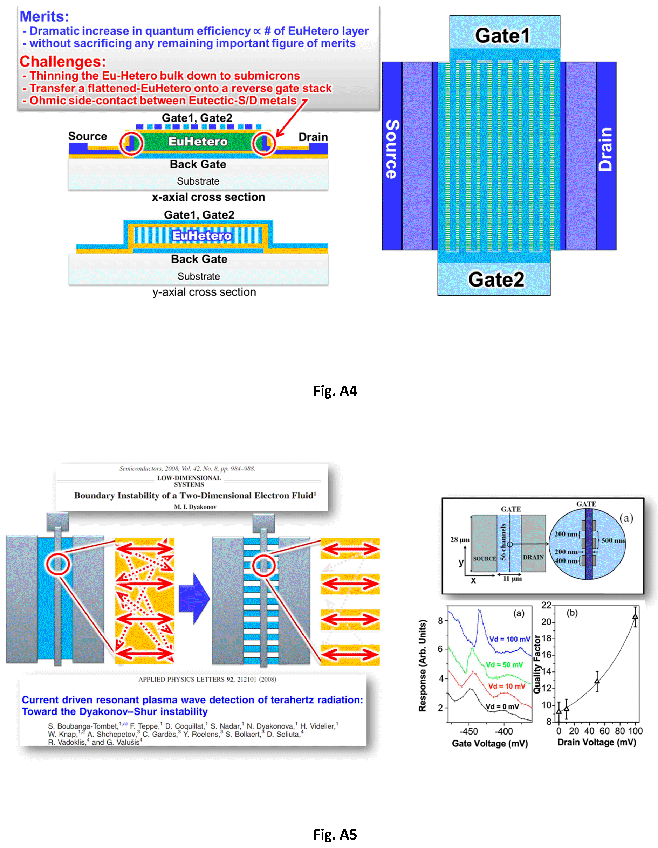

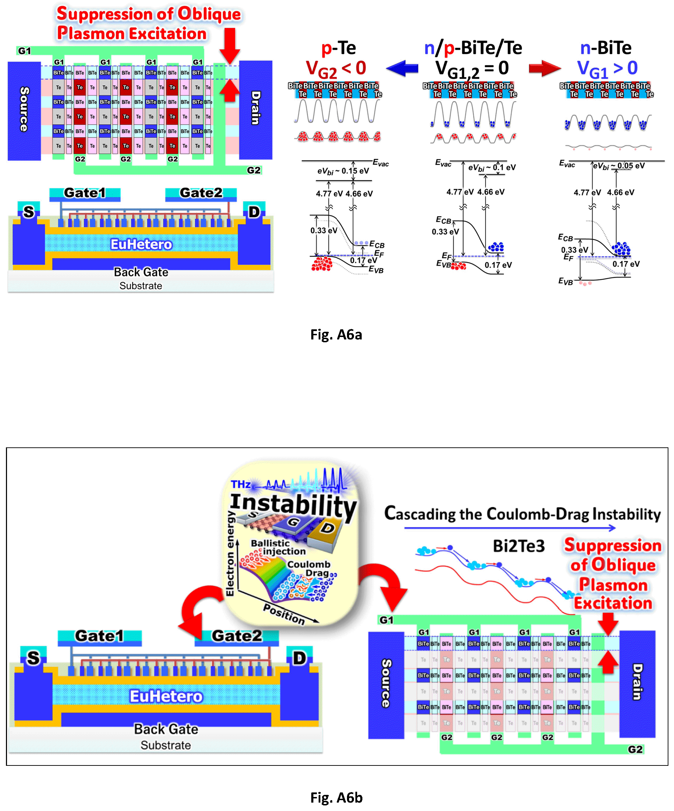

## Claims

1. A laser transistor device consisting of:
(a) a layered back-gate element (1) consisting of a substrate layer (1A), a metal electrode layer (1B), and a gate insulating layer (1C),
(b) a thin-channel element (2) consisting of vertically stacked thin semi-metallic layers (2A) and vertically stacked thin semiconductor or insulating layers (2B), which are arranged layer by layer in an alternating lamellar manner and placed on top of the stacked back-gate element,
(c) an upper gate element (3) consisting of an insulating layer (3A) and a metal electrode layer (3B), arranged on top of the insulating layer (3A),
(d) a first lateral contact layer of a metal electrode, referred to as a "source," which is embedded in order to make electrical contact with one side wall perpendicular to the direction of the layer of a pillar gate element later, and
(e) a second lateral metal electrode layer, referred to as a "drain," which is embedded in order to make electrical contact with a second side wall perpendicular to the direction of the pillar gate element layer.

2. The laser transistor device according to claim 1, **characterized in that** the layered back-gate element (1) comprises a substrate layer (1A), a metal electrode layer (1B), and a gate insulating layer (1C), **in that** order from bottom to top.

3. The laser transistor device according to claim 1, **characterized in that** the layered back-gate element (1) is formed of a metal electrode layer (1B), a substrate layer (1A), and a gate insulating layer (1C) **in that** order from bottom to top, wherein a low-resistance substrate layer (1A) is used, acting as an extension of the metal electrode layer (1B).

4. The laser transistor device according to claim 1, **characterized in that**
a) the metal electrode layer (1B) in the back gate element (1) is completely covered by the area of the thin-channel element (2) and
b) the metal electrode layer (1B) in the upper gate element (3) is formed in the shape of a single narrow finger running perpendicular to the source-drain direction.

5. The laser transistor device according to claim 1, **characterized in that** the metal electrode layer (1B) in the element stacked with the back gate (1) and in the element stacked with the upper gate (3) is formed in the shape of a single narrow finger running perpendicular to the source-drain direction and are arranged so that they overlap.

6. The laser transistor device according to claim 1, **characterized in that** the metal electrode layer (1B) in the element stacked with the back gate (1) and in the element stacked with the upper gate (3) is formed in the shape of a double grating gate, in which one grating gate electrode is nested with the other grating gate electrode, and the double grating gate electrode in the element stacked with the back gate (1) and in the element stacked with the upper gate (3) are arranged so that they overlap.

7. The laser transistor device according to claim 1, **characterized in that** the distance from one gate finger to the gate finger adjacent on the left and to the gate finger adjacent on the right is different from each other.

8. The laser transistor device according to claim 1, **characterized in that** the thin-channel element (2) consists of vertically arranged thin semi-metallic layers (2A) and vertically arranged thin semiconductor or insulating layers (2B), which are arranged layer by layer in an alternating, plate-like manner, wherein the thickness of each individual layer ranges from 10 nanometers to 10 micrometers, such that conduction electrons or valence holes in the vertically arranged thin semi-metallic layers (2A) can be quantum mechanically constrained.

9. The laser transistor device according to claim 1, **characterized in that** the thin-channel element (2) consists of vertically stacked thin semi-metallic layers (2A) and vertically stacked thin semiconducting or insulating layers (2B), which are arranged layer by layer in an alternating, tile-like manner, the height of the vertically stacked channel is between 10 nanometers and 10 micrometers, so that the induced charge densities within the vertically stacked thin semi-metallic layers (2A) can be well controlled electrostatically by applying a voltage to the element with a back gate (1) and the element with a upper gate (3).

10. The laser transistor device according to claim 1, **characterized in that** the thin-channel element (2) consists of vertically stacked thin semi-metallic layers (2A) and vertically stacked thin semiconducting or insulating layers (2B), which are arranged layer by layer in an alternating lamellar manner, is made of two different two-dimensional [2D] topological Dirac semimetals and/or transition metal chalcogenides and/or thin van der Waals insulating layers, which are arranged via van der Waals forces without chemical bonds through exfoliation and dry transfer treatment.

11. The laser transistor device according to claim 1, **characterized in that** the thin-channel element (2) consists of vertically arranged thin semi-metallic layers (2A) and vertically arranged thin semiconductor or insulating layers (2B), which are arranged layer by layer in an alternating lamellar manner, is made of two different topological insulating materials in a eutectic alloyed lamellar heterostructure.

12. The laser transistor device according to claim 1, **characterized in that** the thin-channel element (2), consisting of vertically arranged thin semi-metallic layers (2A) and vertically arranged thin semiconductor or insulating layers (2B), which are arranged layer by layer in an alternating lamellar fashion, is made of a semimetal and a semiconductor or insulating material.

13. The laser transistor device according to claim 1, **characterized in that** the metal electrode layer (3B) in c) the upper gate element is formed in a double-grating-gate structure, in which two independent grating-finger-shaped electrodes are laid out in an interdigitated fashion and are electrically connected to independent top gate terminals (named Gate1 and Gate 2, respectively).

14. The laser transistor device according to claim 1, **characterized in that** the grating-gate electrode in the double-grating-type metal electrode layer (3B) is asymmetrically laid out with respect to the other grating-gate electrode so as to inequal the distances between adjacent left-side grating-gate finger and adjacent right-side grating finger.
